# EUROPÄISCHE PATENTSCHRIFT

(11) **EP 2 452 367 B1**
(45) Veröffentlichungstag und Bekanntmachung des Hinweises auf die Patenterteilung: **07.05.2014**
(21) Anmeldenummer: 10728719.5
(22) Anmeldetag: 08.07.2010
(51) Int. Cl.: H01L 31/052, H01L 31/05, B32B 15/08, B32B 15/20, B32B 17/10, H01R 9/24

(54) **VERBUNDSYSTEM FÜR PHOTOVOLTAIK-MODULE**
COMPOSITE SYSTEM FOR PHOTOVOLTAIC MODULES
SYSTÈME COMPOSITE POUR MODULES PHOTOVOLTAÏQUES

(30) Priorität: 10.07.2009 DE 102009026149
(43) Veröffentlichungstag der Anmeldung: 16.05.2012
(73) Patentinhaber: Eppstein Technologies GmbH, 65817 Eppstein (DE)
(72) Erfinder: REES, Markus, 65817 Eppstein (DE); WAEGLI, Peter, CH-5620 Bremgarten (CH)
(74) Vertreter: Meyer-Dulheuer, Karl-Hermann
(86) Internationale Anmeldenummer: PCT/EP2010/059788
(87) Internationale Veröffentlichungsnummer: WO 2011/003969

(56) Entgegenhaltungen:
- EP-A2- 2 003 698
- WO-A2-2009/025463
- FR-A1- 2 877 144
- JP-A- 2008 047 721
- US-A- 5 951 786
- US-A1- 2008 000 517
- US-A1- 2008 251 120
- US-A1- 2009 065 043
- US-B1- 6 294 725
- US-B1- 6 323 415
- US-B1- 6 350 945

## Beschreibung

Die vorliegende Erfindung betrifft ein Verbundsystem für Photovoltaik (PV)-Module. Das Verbundsystem besteht aus einer Trägerfolie, einer Metallfolie, welche auf die Trägerfolie aufgebracht ist und einer Isolationsschicht, welche auf die Metallfolie aufgebracht wird. Mit unterschiedlichen Verbindungstechniken können dann verschiedene Photovoltaik (PV)-Zellen auf dem Verbundsystem befestigt und durch dieses elektrisch verschaltet werden.

Zudem betrifft die Erfindung ein Verfahren zur Herstellung des Verbundsystems für PV-Module, sowie die Verwendung des Verbundsystems zur Rückseitenkontaktierung von Waferzellen, die beide Kontakte auf der gleichen Seite haben und mit diesen Kontakten auf Leiterbahnstrukturen gesetzt werden, welche diese zu einem Modul verschalten und die Verwendung des Verbundsystems für Module aus intern verschalteten Dünnschichtzellen.

Ein PV-Modul wandelt Sonnenlicht direkt in elektrische Energie um und enthält als wichtigsten Bestandteil mehrere PV-Zellen (bis zu 160 Zellen), die miteinander verschaltet sind. Die Zellen werden hierfür mittels unterschiedlicher Materialien zu einem Verbund zusammengefasst, der mehrere Zwecke erfüllt: Der Verbund bildet eine transparente, strahlungs- und witterungsbeständige Abdeckung und liefert durch die entsprechende Verpackung robuste elektrische Anschlüsse. Die spröden PV-Zellen und elektrischen Verbindungen werden sowohl vor mechanischen Einflüssen als auch vor Feuchtigkeit geschützt. Zusätzlich erlaubt die Verpackung der PV-Zellen eine ausreichende Kühlung derselben. Die elektrischen Bauteile werden vor Zugriffen geschützt und die Module können besser gehandhabt und befestigt werden. Es gibt verschiedenste Bauformen von PV-Modulen mit unterschiedlichen Arten von PV-Zellen.

In der Regel besitzen PV-Module eine Glasplatte auf der zur Sonne gewandten Seite (Frontseite), wobei meist ein sogenanntes Einscheiben-Sicherheits-Glas (ESG) verwendet wird. Über eine transparente Kunststoffschicht, wie beispielsweise Ethylenvinylacetat (EVA) oder Silikongummi, ist diese in der Regel mit den Zellen verbunden. In diese Kunststoffschicht sind die PV-Zellen eingebettet, die durch Lötbändchen elektrisch miteinander verschaltet sind. Auf der Rückseite werden die Module mit einer witterungsfesten Kunststoffverbundsfolie, beispielsweise aus Polyvinylfluorid oder Polyester, oder einer weiteren Glasscheibe, abgeschlossen. Bei der Fertigung von PV-Modulen werden diese in der Regel bei etwa 150°C laminiert. Beim Laminieren bildet sich aus der bis dahin milchigen EVA-Folie eine klare, dreidimensional vernetzte und nicht mehr aufschmelzbare Kunststoffschicht, in der die PV-Zellen eingebettet sind und die fest mit der Glasscheibe und der Rückseitenfolie verbunden ist.

Mono- und mehrkristalline PV-Zellen werden aus sogenannten Wafern (einkristalline oder mehrkristalline Siliziumscheiben) hergestellt, wie sie in gleicher oder ähnlicher Form auch für die Halbleiterherstellung verwendet werden. Diese Siliziumzellen weisen großtechnisch einen Wirkungsgrad von bis zu 20% oder mehr und eine Leistungsdichte von 20 - 50 W/kg auf. Mehrere dieser Zellen werden in einem PV-Modul mittels Lötbändchen zu einzelnen Strängen (sogenannte Strings) in Serie geschaltet, bis die richtige Ausgangsspannung erreicht ist. Mehrere solcher Zellgruppen werden daraufhin parallel geschaltet, um deren Ausgangsströme zu addieren und zu den Modulanschlüssen zu führen. Die dazu verwendeten Leitungen werden als Busbars bezeichnet. Für die Verstringung der Zellen muss jeweils die Vorderseite einer Zelle (z.B. Minuspol) mit der Rückseite der nächsten Zelle (Pluspol) verbunden werden, wozu häufig verzinnte Kupferbändchen eingesetzt werden.

Da die Verbindung der Frontseite einer Zelle mit der Rückseite der jeweiligen Nachbarzelle aufwendig und schwer zu automatisieren ist, wird verstärkt an der Rückseitenkontaktierung gearbeitet. Insbesondere, wenn aus Gründen der Kosteneinsparung immer dünnere Wafer verwendet werden, sind diese aufgrund der erhöhten Bruchgefahr schwieriger zu handhaben. Zudem schatten die über die Frontseite verlaufenden Anschlussbändchen einen Teil des Lichts ab, der damit nicht zur Stromerzeugung genutzt werden kann, so dass der Wirkungsgrad der Zellen und des gesamten Moduls sinkt. Ein Ansatz, um zusätzlich die optischen Verluste, die durch die zur Verstringung benötigten Bändchen entstehen, zu reduzieren, ist in der US 2007/0125415 A1 beschrieben. Hierbei werden sogenannte "Light Harvesting Strings" eingesetzt, genauer gesagt Bändchen, welche das Licht, das an der Vorderseite die Kontaktierung erreicht, also abgeschattet würde, unter einem Winkel so zurückreflektieren, dass es an der Oberseite des Deckglases in die Zelle reflektiert wird. Allerdings sind solche Bändchen teuer, da sie eine Silberoberfläche aufweisen und schwierig mit den Zellen zu verbinden sind, ohne dass die zur Reflexion benötigte Oberflächenstruktur zerstört wird. Bei der Rückseitenkontaktierung wird der Frontkontakt durch entsprechende Auslegung der Zelle auf die Rückseite geführt, so dass beide Kontakte (+/-) auf der gleichen Seite zugänglich sind. Damit können bei der Modulherstellung sogenannte "Pick-und-Place"-Techniken angewandt werden, bei denen die Zellen automatisch auf die Kontaktstruktur einer gedruckten Schaltung (Leiterplatte) platziert werden können und mit dieser über Löt-, Steck- oder Klebeverbindungen verbunden werden können. Ein solches PV-Modul mit Rückseitenkontakt ist beispielsweise in der EP 1 449 261 B1 beschrieben. Die Kontaktierung erfolgt nur noch von einer Seite, was die Handhabung vereinfacht und gleichzeitig die Abschattung durch das Bändchen beseitigt.

Die Leiterplatten, die hinter jeder Zelle angeordnet sind, verleihen den Wafern zusätzlich Stabilität, was sich insbesondere bei dünnen Wafern vorteilhaft auswirkt. Allerdings sind solche Leiterplatten teuer und müssen wiederum miteinander verbunden werden, was entweder die Verbindungen einzelner Leiterplatten notwendig macht oder sehr große Leiterplatten (in Modulgröße) voraussetzt, die entsprechend aufwendig zu fertigen sind. Außerdem bestehen diese Waferzellen-Module aus vielen unterschiedlichen Komponenten, die in jeweils einzelnen Arbeitsschritten verarbeitet werden müssen, was aufwendig und kostenintensiv ist. Aufgabe der vorliegenden Erfindung ist demnach, die genannten Nachteile des Standes der Technik zu überwinden, und einen einfacheren und kostengünstigeren Aufbau von Waferzellen-Modulen, insbesondere bei immer dünneren Waferzellen, zu erlauben. Mit der Verwendung von immer dünneren Wafern ist jedoch davon auszugehen, dass ein Teil des Lichtes nicht mehr im Wafer absorbiert wird, sondern durch diesen dringt. Es ist daher wünschenswert, dieses Licht wieder in die Zelle zurückzureflektieren, wo ein weiterer Teil absorbiert werden kann.

Im Gegensatz zu den mono- und mehrkristallinen PV-Zellen (Waferzellen) bestehen sogenannte Dünnschichtzellen meist aus einer dünnen Halbleiterschicht aus amorphem und/oder mikrokristallinem Silizium (a-Si bzw. µ-Si), aber auch Cadmium Tellurid (CdTe), Kupfer-Indium-Diselenid (CIS) oder andere Materialien. Der Modulwirkungsgrad von Dünnschichtmodulen beträgt aufgrund der reduzierten Dicke der Silizium- bzw. Halbleiterschicht zwischen 5 und 7% und die Leistungsdichte beträgt bis etwa 2000 W/kg. Mittels der Kombination von amorphem mit kristallinem Silizium, wie beispielsweise mikrokristallinem Silizium, können durch eine bessere Ausnutzung des Lichtspektrums höhere Wirkungsgrade von bis zu 10% erreicht werden. Bei der Herstellung von Dünnschichtmodulen wird die aktive Halbleiterschicht, typischerweise amorphes und/oder mikrokristallines Silizium, mit speziellen Beschichtungsprozessen auf eine Glasplatte oder auf einen flexiblen Träger, typischerweise Stahl- oder Kupferbänder, aufgebracht. Ein Vorteil bei der Herstellung von Modulen in Dünnschichttechnologie ist die einfache Verschaltung der Zellen. Nach der Beschichtung mit dem aktiven Material wird diese mittels spezieller Laserprozesse in Zellen unterteilt, die miteinander verstringt sind. Die externe Verstringung mittels Bändchen, wie sie in Waferzellen-Modulen benutzt wird, entfällt somit. Zur Stromabnahme werden jedoch weiterhin Bändchen für die so genannten Busbars zur Ableitung des erzeugten Stroms verwendet. Silizium-Dünnschicht PV-Zellen sind beispielsweise in DE 44 10 220 B4 und DE 10 2006 044 545 A1 beschrieben.

Die am häufigsten eingesetzten Dünnschichtzellen-Modultypen bestehen aus einer (antireflexbeschichteten) Glasplatte, auf welche eine elektrisch leitende und optisch transparente Schicht aufgetragen wird (Transparent Conductive Oxide - TCO, meist Zinkoxid). Diese Schicht bildet den Frontkontakt und wird mittels Laser strukturiert, um die Zellenaufteilung zu erreichen. Darauf wird eine aktive Schicht, beispielsweise Silizium aufgetragen und auf diese der Rückseitenkontakt und ein Reflektor, da das Licht mehrmals durch die dünne aktive Schicht (1-2 µm) geleitet werden muss, um genügend absorbiert zu werden. Dahinter wird das Modul abgeschlossen und gegen Umwelteinflüsse geschützt. Der Rückseitenreflektor kann hierbei aus einer Metallbeschichtung bestehen, dessen raue Textur eine diffuse Reflexion ermöglicht und gleichzeitig als Leiter dient, welcher für die Verstringung der Zellen zuständig ist (integrierter Rückkontakt und Reflektor); oder der Reflektor wird in Form weißer Farbe aufgetragen, welche diffus reflektiert. In diesem Fall ist zwischen der aktiven Schicht und der weißen Farbe ein optisch transparenter Leiter für die Verstringung notwendig, in der Regel TCO.

Bei Dünnschichtmodulen mit integriertem Rückkontakt und Reflektor ist von Nachteil, dass die Eigenschaften von Reflektor und Kontakt nicht getrennt optimiert werden können. Wird beispielsweise die Textur der entsprechenden Schicht verstärkt, verbessern sich zwar die diffusen Reflexionseigenschaften, gleichzeitig vergrößert sich jedoch der elektrische Widerstand. Des Weiteren kann die Textur über die Einstellung der Beschichtungsprozesse nur eingeschränkt kontrolliert werden. Außerdem wirkt sich die Metallschicht störend auf den Laserprozess aus, mit dem das Modul in Zellen unterteilt wird. Unkontrolliert auftretende Metallspritzer können Kurzschlüsse auslösen, die Teile des Moduls zerstören können. Die zum Abschluss des Moduls eingesetzten Kunststoffe sind teuer und schwierig zu verarbeiten. Dünnschichtmodule mit getrenntem Reflektor und Rückkontakt sind demnach einfacher herzustellen. Die als Reflektor eingesetzte Farbe bringt jedoch Nachteile mit sich, da die zu erreichenden Reflexionswerte über einen größeren Wellenlängenbereich ungenügend sind. Dies wirkt sich besonders nachteilig aus, wenn Zellen/Module realisiert werden sollen, die aus mehreren aktiven Schichten bestehen und zusammen einen breiteren Wellenlängenbereich abdecken, um den gesamten Wirkungsgrad des Moduls zu vergrößern.

Bei beiden Varianten von Dünnschichtmodulen müssen beidseitig entlang der Längsrichtung des Moduls Busbars in Form von Bändchen angebracht werden. Aufgrund der Länge der Bändchen und deren inhärenten Säbeligkeit ist dieses aufwendig und teuer. Als weiterer Nachteil stellt sich zunehmend der Aufbau der Bändchen aus zinnbeschichtetem Kupfer heraus. Wenn die Zinnschicht verletzt ist oder vollständig fehlt, kann von der freigelegten Kupferoberfläche Korrosion ausgehen, die die Lebensdauer des Moduls reduziert. Die Module bestehen insgesamt aus vielen Komponenten, die in mehreren Arbeitsschritten verarbeitet werden müssen, was kostenintensiv, aufwendig und fehleranfällig ist. Aufgabe der vorliegenden Erfindung ist demnach zusätzlich, einen einfacheren und kostengünstigeren Aufbau von Dünnschichtmodulen zu erlauben.

Gelöst wird die Aufgabe durch das erfindungsgemäße Verbundsystem, dem Verfahren zur Herstellung eines solchen Verbundsystems, sowie deren Verwendung für unterschiedliche PV-Module. Dieses Verbundsystem erfüllt mehrere Funktionen, die für die Zusammenschaltung und den Anschluss von Photovoltaik-Zellen und -Modulen sowie zum Abschluss der Module und deren Schutz vor Umwelteinflüssen notwendig sind. Hierbei wird in den Zellen nicht absorbierte Strahlung in diese zurückreflektiert, so dass sie wiederverwertet werden kann. Das erfindungsgemäße Verbundsystem erlaubt so eine einfache und kostengünstige Produktion von Photovoltaikmodulen und eine Verbesserung der Effizienz und Zuverlässigkeit. Das vorgeschlagene Verbundsystem eignet sich somit sowohl für die Rückkontaktierung von Waferzellen-Modulen als auch für Dünnschichtzellenmodule. Die Ausbildung, Strukturierung und Kontaktierung des Leiters bestimmt letztendlich, für welche Anwendung das Verbundsyste eingesetzt wird.

Das Verbundsystem für Photovoltaik-Anwendungen besteht aus einer Trägerfolie, mit Hilfe welcher das Modul gegen Umwelteinflüsse verschlossen wird und die weiteren Funktionsschichten trägt. Auf die Trägerfolie ist eine Metallfolie aufgebracht, die entsprechend strukturiert zur Verstringung der Zellen und als Busbar genutzt wird (elektrische Funktion) und gleichzeitig eine optische Funktion ausführt, indem sie als Reflektor dient. Die Metallfolie ist derart ausgestaltet, dass diese mit einer Oberflächentextur versehen ist. Eine Isolationsschicht wird haftend auf die Metallfolie aufgebracht und isoliert die Zelle elektrisch von der Metallfolie. An den Kontaktstellen wird diese Schicht entfernt. Dies kann durch mechanische Abtragung oder eine Abtragung mittels Laser geschehen. Die Isolationsschicht ist außerdem mit einem Verbindungsmittel versehen. Dies erleichtert das Fixieren von Zellen auf dem Folienverbund. Das Licht, welches durch die aktive Schicht dringt, wird zur Metallfolie durchgelassen, so dass es von dieser zurück in die aktive Schicht reflektiert wird.

Mittels unterschiedlicher Verbindungstechniken kann das Verbundsystem mit den PV-Zellen stabil verbunden werden. In einer vorteilhaften Ausgestaltungsform des erfindungsgemäßen Verbundsystems wird dieses mit Hilfe eines elektrisch leitenden Klebers mit den Zellen verbunden. In einer alternativen Ausgestaltung wird diese Verbindung mechanisch durch Verpressen oder durch Laserbearbeitung hergestellt.

Alternativ ist es ebenfalls möglich, dass während der Lamination gleichzeitig elektrische Verbindungen durch Löten hergestellt werden, vorzugsweise mittels tiefschmelzendem Lot.

Bei dem Verbindungsmittel auf der Isolationsschicht kann es sich um einen Kleber handeln. Dies hat den Vorteil, dass die Handhabung der Zellen erheblich erleichtert wird. Es ist somit möglich, die Photovoltaik-Zellen bereits haftend auf dem Folienverbund zu fixieren, bevor diese in den Laminator gelangen. Durch den Vorgang der Lamination werden diese dann endgültig mit dem Folienverbund verbunden.

Die Trägerfolie besteht vorzugsweise aus Polyvinylbutyral (PVB), Polyvinylfluorid, Ethylenvinylacetat (EVA) oder einem Kunststoff mit vergleichbaren thermischen und physikalischen Eigenschaften.

In einer alternativen Ausgestaltungsform besteht die Trägerfolie vorzugweise aus Polyethylenterephthalat in Form von biaxial orientiertem Polyester (boPET). Dadurch wird dem Verbundsystem zusätzliche mechanische Stabilität verliehen.

Alternativ kann auch eine Schichtdicke von 25 µm bis 100 µm besonders bevorzugt, 40 µm bis 80 µm verwendet werden, um die Leitfähigkeit zu verbessern und die ohmschen Verluste im Modul zu reduzieren.

In einer weiteren vorteilhaften Ausgestaltungsform ist die Trägerfolie auf der Rückseite beschichtet, vorzugsweise mit Aluminium. Dies ist insbesondere dann vorteilhaft, wenn die Trägerfolie den Modulabschluss bildet.

Die Metallfolie, welche auf die Trägerfolie haftend aufgebracht wird besteht vorzugsweise aus Zinn oder einer Zinnlegierung, oder einer plattierten Zinnfolie. Es ist ebenfalls möglich, hierfür Kupfer, Aluminium oder Silber einzusetzen. In einer weiteren vorteilhaften Ausgestaltung weist die Metallfolie eine Dicke von mindestens 5 µm auf, vorzugsweise 5-25 µm und besonders bevorzugt 10-20 µm.

In einer weiteren vorteilhaften Ausgestaltung der vorliegenden Erfindung ist die Metallfolie mit einer Schicht versehen, die die Reflexion erhöht. Vorzugsweise handelt es sich hierbei um eine mit einer Silberoberfläche beschichte Zinnfolie oder mit Siliziumdioxid und/oder Titandioxid beschichtetes Aluminium. Diese Schicht ermöglicht eine besonders effiziente Reflexion des Lichts, das durch die aktive Schicht dringt. Diese Schicht sollte eine Reflexion von > 80% im Wellenlängenbereich von 300 nm bis 1000 nm aufweisen.

In einer weiteren vorteilhaften Ausgestaltung ist die Metallfolie mit einer Oberflächentextur versehen. Diese stellt sicher, dass das Licht so zurückreflektiert wird, dass ein möglichst effektives "Light Trapping" erzielt wird. Die Oberflächentextur besteht vorzugsweise aus dreidimensionalen, regelmäßigen oder unregelmäßigen Strukturen. Besonders bevorzugt besteht die Oberflächentextur der Metallfolie aus Pyramiden oder Halbkugeln. Hierbei ist es von Vorteil, wenn die Oberflächentextur und/oder die Pyramiden oder Halbkugeln eine Höhe von 1-20 µm, vorzugsweise 5-15 µm, besonders bevorzugt 5-10 µm aufweist. Es ist weiterhin von Vorteil, wenn die Oberflächentextur und/oder die Pyramiden oder Halbkugeln eine zufällige Höhenverteilung von 1-20 µm, vorzugsweise 5-15 µm, besonders bevorzugt 5-10 µm aufweisen. In einer weiteren vorteilhaften Ausführungsform besteht die Oberflächentextur aus Pyramiden der bevorzugten Größe mit einem Scheitelwinkel von < 160°, vorzugsweise < 140°.

In einer weiteren alternativen Ausgestaltung besteht die Oberflächentextur der Metallfolie aus Pyramiden oder Halbkugeln, die eine charakteristische Größe von höchstens 1000 nm aufweisen. Es ist weiterhin bevorzugt, wenn die Oberflächentextur und/oder die Pyramiden oder Halbkugeln eine zufällige Höhenverteilung von 10-1000 nm, vorzugsweise 100-1000 nm aufweisen.

In einer weiteren vorteilhaften Ausgestaltung der vorliegenden Erfindung besteht die Isolationsschicht, welche haftend auf die Metallfolie aufgebracht ist, aus einem optisch transparenten und elektrisch isolierenden Material. Vorzugsweise handelt es sich hierbei um einen geeigneten Kunststoff oder ein Kunstharz. Bei dem Kunstharz handelt es sich vorzugsweise um ein Epoxid-Harz. Optional kann diese Schicht auch mit einem physikalische Gasabscheidungs (PVD)-Verfahren oder mit einem Sol-Gel Verfahren auf der Metallfolie aufgebracht werden. Diese Schicht soll die Metallschicht elektrisch von der Zelle isolieren und eine gewisse Durchschlagsfestigkeit aufweisen. Zusätzlich soll diese Schicht aber auch im Bereich von 400 nm bis 1000 nm optisch transparent sein (Absorptionskoeffizient α<3*10⁻³/cm). Zudem sollte die Isolationsschicht im erwähnten Wellenlängenbereich einen Brechungsindex aufweisen, der größer ist als der Brechungsindex des als Eintrittsfenster verwendeten Glases. Der Brechungsindex beträgt in diesem Bereich vorzugsweise > 1,4, besonders bevorzugt > 1,6. An den Kontaktierungsstellen ist die Isolationsschicht unterbrochen, damit elektrische Kontakte zwischen der Metallschicht innerhalb des Verbundsystems und der PV-Zellen hergestellt werden können.

Vorzugsweise handelt es sich bei dem geeigneten Kunststoff, der für die Isolationsschicht verwendet wird, um PVB. Dieses Material hat den Vorteil, dass gleichzeitig eine Haftung der Folie auf den Zellen während des Laminationsprozesses bzw. des vorgeschalteten Montageprozesses der Zelle erreicht wird. Letzteres kann besonders vorteilhaft sein, da dadurch der Transport des assemblierten und montierten Moduls in den Laminator vereinfacht wird und verhindert wird, dass sich Komponenten während des Laminationsprozesses verschieben. Dazu kann das Foliensystem während des Montageprozesses der Zelle (Pick- und Place) erwärmt werden, so dass das PVB haftend wird und die Zelle fixiert.

Das Verfahren zur Herstellung eines Verbundsystems für PV-Module beinhaltet die folgenden Verfahrensschritte: Eine vorzugsweise texturierte Metallfolie wird mit einer Trägerfolie durch eine haftende Verbindung zusammengefügt. Danach wird die Metallfolie beispielsweise mittels eines Laserprozesses lokal abgetragen und somit derart strukturiert, dass die für die Busbars und/oder die Verstringung benötigte Leiterbahnstruktur entsteht. Anschließend werden diese zusammengefügten Schichten mit der Isolationsschicht verbunden; und die Isolationsschicht wird an bestimmten Stellen geöffnet, um die elektrischen Kontakte herzustellen. Aus Gründen des Oberflächenschutzes kann es vorzuziehen sein, die Kontaktöffnungen erst kurz vor dem Laminieren vorzunehmen. Abhängig von der Strukturierung der Metallfolie eignet sich das Verbundsystem für die Herstellung von Waferzellen oder Dünnschichtzellen. Das Verbinden der einzelnen Folien erfolgt bevorzugt durch Kaschur oder durch die haftende Eigenschaften der Folie selbst. Alternativ ist es ebenfalls möglich, zunächst die Metallfolie mit der Isolationsschicht zu verbinden und anschließend diese Schichten mit der Trägerfolie zu verbinden.

Als letztes wird ein Verbindungsmittel auf die Kontaktierungsöffnungen aufgetragen. Vorzugsweise handelt es sich bei dem Verbindungsmittel um einen thermisch aushärtenden, elektrisch leitenden Kleber, so dass die elektrischen Verbindungen zu den PV-Zellen während des Laminierungsprozesses hergestellt werden können. Alternativ kann die elektrische Verbindung zwischen dem Verbundsystem und Wafer- bzw. Dünnschichtzellen über einen Laserlötprozess erfolgen. In diesem Falle ist allerdings ein zusätzlicher Arbeitsgang zur Verarbeitung notwendig. Eine weitere Alternative der elektrischen Verbindung ist das mechanische Verpressen des Verbundsystems mit den Kontaktierungsöffnungen.

Für den Fall, dass das Verbundsystem für, die Rückseitenkontaktierung von Waferzellen-Modulen eingesetzt wird, führt dies zu einer starken Kostenminimierung, da keine teuren Leiterplatten eingesetzt werden brauchen. Zudem werden die Reflektoren direkt in die Leiterstruktur integriert, was die Verwendung dünnerer Wafer erlaubt.

In einer weiteren vorteilhaften Ausgestaltung des erfindungsgemäßen Verfahrens zur Herstellung eines Verbundsystems für PV-Module wird vor dem Verbinden von Trägerfolie und Metallfolie die gewünschte Reflektortextur in die Metallfolie geprägt. In einer alternativen vorteilhaften Ausgestaltung wird die Reflektortextur in die mit der Metallfolie verbundene Trägerfolie geprägt, oder von einer geprägten Isolationsschicht bei dem Verbinden auf die Metallfolie übertragen. Diese Textur stellt sicher, dass das Licht so zurückreflektiert wird, dass möglichst viel Licht in die PV-Zelle zurückgeführt und dort absorbiert wird ("Light Trapping").

Die Metallschicht kann in einer weiteren alternativen Ausgestaltungsform perforiert sein, so dass eine bessere Haftung zu den benachbarten Schichten hergestellt werden kann.

In einer weiteren vorteilhaften Ausgestaltung wird als Trägerfolie vorzugsweise Polyvinylbutyral (PVB) eingesetzt, welches in der Herstellung von Verbundgläsern verwendet wird, und mit welchem viel Anwendungserfahrung besteht. Zudem wird PVB bereits heute bereits in Modulen eingesetzt, so dass die für die Verwendung des Verbundsystems notwendigen Prozessanpassungen für den Modulhersteller weniger einschneidend ausfallen.

Als Material für die Isolationsschicht wird vorzugsweise ein Kunstharz, besonders bevorzugt ein Epoxid-Harz verwendet. Wenn beispielsweise die Textur in die Metallfolie geprägt wurde, kann diese daraufhin mit Epoxid-Harz ausgegossen und stabilisiert werden. Dieses Epoxid-Harz darf im Laminationsprozess nicht wieder weich werden, damit die Textur erhalten bleibt. Das Epoxid-Harz kann mittels Temperatur und/oder UV-Strahlung ausgehärtet werden. Zusätzlich soll diese Schicht aber auch im Bereich von 300 nm bis 1000 nm optisch transparent sein (α<3*10⁻³/cm) und einen Brechungsindex aufweisen, der größer ist als der Brechungsindex des zur Anwendung gelangenden Frontglases. Der Brechungsindex beträgt in diesem Bereich vorzugsweise > 1,4, besonders bevorzugt > 1,6. An den Kontaktierungsstellen zwischen der Metallfolie im Verbundsystem und den PV-Zellen weist die Isolationsschicht Unterbrechungen auf.

In einer bevorzugten Ausgestaltungsform der Erfindung wird die Isolationsschicht in Form einer Beschichtung auf der Metallfolie aufgebracht. Dies kann beispielsweise durch PVD- oder Sol-Gel Prozesse erfolgen. Vorteil dieser Beschichtungsarten sind optimierte Eigenschaften sowie geringe und definierte Schichtdicken.

In einer weiteren vorteilhaften Ausgestaltung des erfindungsgemäßen Verfahrens wird die Metallfolie in Transportrichtung während des Verbindens beschnitten. Vorzugsweise kann dies mittels eines Laserverfahrens erfolgen. Somit kann das Verbundsystem bereits in der gewünschten Form und Größe produziert werden.

Das somit hergestellte Verbundsystem kann in einem Prozess, beispielsweise Lamination oder Verpressen mit den PV-Zellen verbunden werden, so dass eine Verschaltung der Zellen zum Modul entsteht (Verstringung). Zusätzlich wird über die Trägerfolie ein Anschluss nach außen hergestellt und das Modul wird so abgeschlossen, dass es vor Umwelteinflüssen geschützt ist.

In einer alternativen Ausgestaltungsform des erfindungsgemäßen Verfahrens werden während des Laminationsvorganges in einem Verfahrensschritt zusätzlich elektrische Verbindungen zwischen dem Verbundsystem und den PV-Zellen hergestellt, vorzugsweise mittels Löten besonders bevorzugt unter Verwendung von tiefschmelzendem Lot; das Modul nach hinten verschlossen; ein Deckglas aufgebracht und/oder die Einbettung der PV-Zellen bewerkstelligt.

Gegenstand der Erfindung ist zudem einerseits die Verwendung des erfindungsgemäßen Verbundsystems zur Rückseitenkontaktierung von Waferzellen-Modulen. Waferzellen, bei welchen beide Kontakte auf einer Seite liegen, werden mit diesen Kontakten auf die Leiterbahnstrukturen gesetzt und mit diesen verbunden. Die Verbindung kann während der Lamination erfolgen, indem in diesem Verfahrensschritt gleichzeitig die elektrischen Zellenverbindungen hergestellt werden. Mehrere Waferzellen können somit zu einzelnen Strängen verbunden und schließlich durch Busbars zu einer größeren Einheit in einem Waferzellen-Modul zusammengefasst werden. Während des Laminationsvorganges wird der Kontakt zwischen den Zellen und der entsprechenden, in die Metallfolie geschnittenen Leiterbahnstruktur entweder durch rein mechanisches Kontaktieren, durch Verpressen oder durch die Aushärtung eines elektrisch leitenden Klebers hergestellt.

Alternativ ist es ebenfalls möglich, dass während der Lamination gleichzeitig elektrische Verbindungen durch Löten hergestellt werden, vorzugsweise mittels tiefschmelzendem Lot.

Andererseits ist die Verwendung des beschriebenen Verbundsystems für die Herstellung von Dünnschichtzellenmodule Gegenstand der vorliegenden Erfindung. Hierfür wird die Isolationsschicht an den Längsseiten der Modulränder für die Kontaktierung der Metallfolie geöffnet. Diese muss die aktive Schicht in Segmenten oder über die gesamte Länge des Moduls an den Modulrändern kontaktieren. Die Metallfolie wird längsseitig in zwei Teile geteilt, so dass eine Leiterbahnstruktur entsteht, welche gleichzeitig als Busbars dient. Diese zwei Reflektorstreifen sind durch die Isolationsschicht auf der Fläche elektrisch von der aktiven Schicht isoliert. Aufgrund der fehlenden Isolationsschicht an den Rändern des Dünnschichtzellenmoduls muss die Trägerfolie diese Dickendifferenz ausgleichen. Somit ist gewährleistet, dass die Modulabdeckungen fest mit dem Verbundsystem verbunden werden können und keine Feuchtigkeit in das Modul eindringt.

In einer weiteren vorteilhaften Ausgestaltungsform der Verwendung des erfindungsgemäßen Verbundsystems zur Rückseitenkontaktierung von Waferzellen-Modulen oder zur Herstellung von Dünnschichtzellenmodule bildet die Trägerfolie den rückseitigen Modulabschluss als Schutz vor Umwelteinflüssen. Alternativ ist es möglich, dass die Trägerfolie eine mechanisch feste Verbindung mit einer rückseitigen Modulabdeckung eingeht, die beispielsweise aus einer Glasplatte oder aus einer weiteren zusätzlichen Kunststofffolie bestehen kann.

Durch den Einsatz des erfindungsgemäßen Verbundsystems ergeben sich mehrere Vorteile gegenüber dem Stand der Technik. Zum Einen werden die Materialkosten reduziert. Die Bändchen für die Busbars und für die Verstringung innerhalb der Waferzellen-Module entfallen. Ebenso wird keine Reflektorfarbe im Fall der Dünnschichtmodule eingesetzt. Es müssen keine teuren Leiterplatten verwendet werden und insgesamt werden weniger Komponenten verarbeitet. Zum Anderen wird die Anzahl der Arbeitsschritte bei der Modulherstellung verringert. Das Herstellen der elektrischen Zellenverbindungen, das Kontaktieren und das Verschließen des Moduls können in einem Arbeitsgang durchgeführt werden. Die aufwendige Montage der Bändchen entfällt und die für Rückseitenkontaktierung vorgesehenen Waferzellen können direkt mit "Pick- und-Place"-Prozessen bestückt werden, da alle elektrischen Verbindungen in einer Ebene angeordnet sind. Ein weiterer Vorteil ergibt sich aus der Tatsache, dass das Verbundsystem, abhängig von der Strukturierung und Kontaktierung des Leiters, sowohl für Waferzellen als auch für Dünnschichtzellen eingesetzt werden kann. Dies bringt auch weitere Vorteile für Anlagen- und Modulhersteller mit sich, da beide Typen von Modulen hergestellt werden und somit viele Prozesse vereinheitlicht werden können. Die hergestellten PV-Module weisen schließlich eine Reihe besserer Eigenschaften auf. Durch die Verwendung der Leiterbahnen als Reflektoren bei Waferzellen-Modulen, beziehungsweise eine bessere Reflexion innerhalb der Dünnschichtmodule, wird die Effizienz gesteigert. Die Lebensdauer der Module wird erhöht, da kein Kupfer mehr verwendet wird. Da die Module aus weniger Komponenten aufgebaut sind, wird insgesamt eine bessere Zuverlässigkeit und geringere Kosten erreicht.

Ein weiterer Vorteil ist die erreichbare Effizienzsteigerung die sich ergibt durch die Wiederverwendung ungenutzter Strahlung, Verkleinerung der ohmschen Verluste durch entsprechende Gestaltung der Metallschicht (Material und Querschnitt).

Im Folgenden soll die Erfindung anhand von Zeichnungen näher erläutert werden, wobei sich die Erfindung selbstverständlich nicht auf die dargestellten Ausgestaltungen beschränkt. Dabei zeigen:
- Fig. 1:: einen schematischen Querschnitt durch das erfindungsgemäße Verbundsystem für Photovoltaik-Anwendungen;
- Fig. 2:: eine schematische Darstellung einer möglichen Ausführungsform einer Zellenverschaltung bei Waferzellen-Modulen;
- Fig. 3:: einen schematischen Querschnitt durch das erfindungsgemäße Verbundsystem für die Rückseitenkontaktierung von Waferzellen-Modulen;
- Fig. 4:: eine Übersicht über ein Verbundsystem für Dünnschichtmodule des Typs "Getrennter Reflektor und Rückkontakt"; und
- Fig. 5:: einen schematischen Querschnitt durch eine mögliche Schichtstruktur des erfindungsgemäßen Verbundsystems für Dünnschichtmodule.

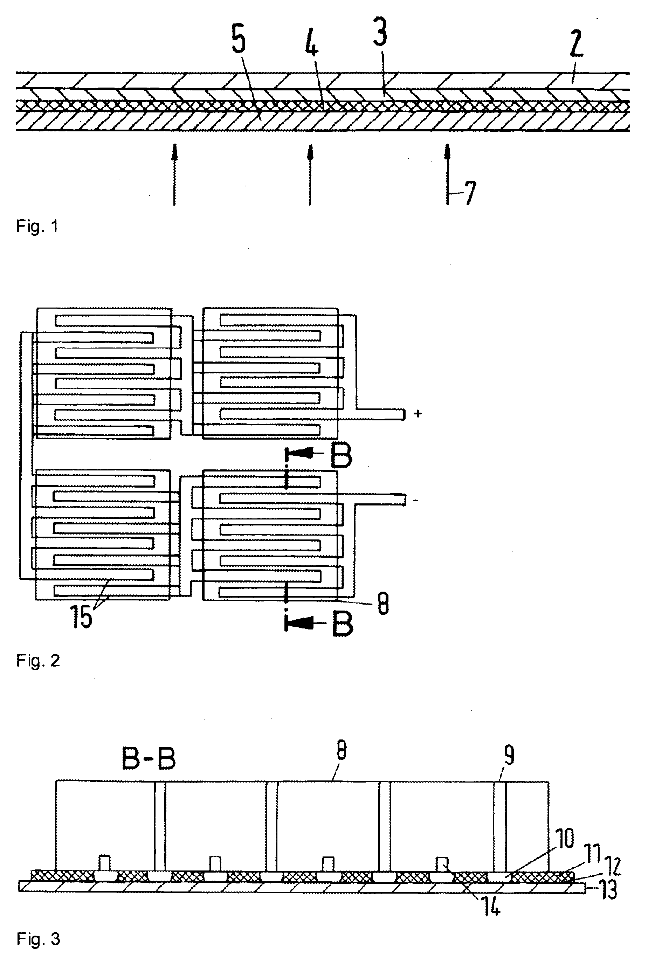

Fig. 1 zeigt einen schematischen Querschnitt durch das erfindungsgemäße Verbundsystem für Photovoltaik-Anwendungen. Eine sogenannte Trägerfolie 2, beispielsweise aus Polyvinylbutyral (PVB) trägt die weiteren Funktionsschichten und stellt die Verbindung zum Verschluss des Moduls gegen Umwelteinflüsse her. Auf dieser Schicht ist eine Metallfolie 3 haftend aufgebracht, die beispielsweise aus Zinn hergestellt ist und eine Dicke von über 5 µm und eine Leiterbahnstruktur aufweist (Fig. 2). Diese Schicht dient der Verstringung der Zellen und wird als Busbar genutzt, funktioniert jedoch gleichzeitig als Reflektor. Auf dieser Metallfolie ist eine Isolationsschicht 4 aufgebracht, die die Metallfolie 3 von der Zelle isoliert. Mit Hilfe beispielsweise eines Klebers ist die aktive Schicht 5, wie zum Beispiel eine Wafer- oder Dünnschichtzelle, mit der Isolationsschicht 4 verbunden. Die Isolationsschicht 4 muss an den Stellen, an denen die elektrischen Kontakte hergestellt werden sollen, Unterbrechungen aufweisen (in dieser Abbildung nicht dargestellt). Das Licht 7 fällt auf die aktive Schicht 5, und der Teil des Lichts, der durch die aktive Schicht 5 dringt, wird durch die Metallfolie 3 zurückreflektiert, um wieder in die aktive Schicht 5 zu gelangen.

Fig. 2 zeigt eine schematische Darstellung einer möglichen Ausführung einer Zellenverschaltung (Verstringung) 15 in Waferzellen-Modulen. Die Leiterbahnen werden aus der Metallfolie geschnitten und beispielsweise mit einem elektrisch leitenden Kleber versehen. Die Waferzellen 8, bei denen beide Kontakte (+/-) auf derselben Seite lokalisiert sind, werden auf diese Leiterbahnen gesetzt und bei der Lamination mit dem erfindungsgemäßen Verbundsystem verbunden. Dadurch entsteht die Verstringung 15 der Waferzellen 8 mit dem Verbundsystem, und das Modul wird nach außen hin abgeschlossen.

In Fig. 3 ist ein schematischen Querschnitt durch das erfindungsgemäße Verbundsystem für die Rückseitenkontaktierung von Waferzellen-Modulen dargestellt. Sowohl die Frontkontakte 9 als auch die Rückkontakte 14 sind auf der Unterseite der Waferzelle 8 lokalisiert. Somit kann eine elektrische Verbindung 10 beispielsweise über einen Leitkleber hergestellt werden. An den Kontaktstellen ist die Isolationsschicht 11 unterbrochen, so dass die Kontakte der Waferzellen 9,14 eine Verbindung zu den reflektierenden Leiterbahnen 12 aufnehmen können, die auf die Trägerfolie 13 aufgebracht sind. Wenn das Licht durch die Waferzelle 8 dringt, wird es an den Leiterbahnen 12 reflektiert, so dass es wieder in die Waferzelle gelangt, um eine höhere Energieausbeute zu ermöglichen.

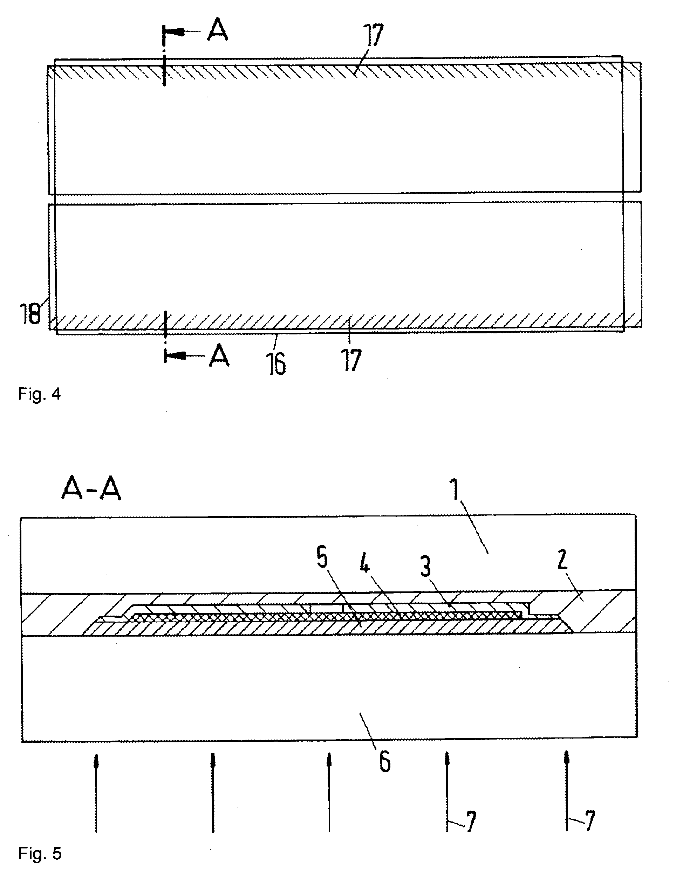

Fig. 4 stellt eine Übersicht über ein Verbundsystem für Dünnschichtmodule des Typs "Getrennter Reflektor und Rückkontakt" dar. Die Metallfolie wird hierbei längsseitig, entlang der Mitte des Moduls in zwei Teile geteilt, die als Busbars dienen und zusätzlich einen texturierten Reflektor 18 bilden. Diese beiden Reflektorstreifen sind durch die Isolationsschicht auf der Fläche elektrisch von der aktiven Schicht, in diesem Fall einer Dünnschichtzelle mit interner Verstringung 16, isoliert. An den Rändern der aktiven Schicht ist die Isolationsschicht entfernt, so dass dort das Modul zur Stromabnahme kontaktiert werden kann 17. Damit funktionieren die Reflektorschichten als Busbars.

Wie in Fig. 5 im Querschnitt dargestellt, muss die Trägerfolie 2 die bestehende Dickendifferenz aufgrund der fehlenden Isolationsschicht 4 an den Modulrändern ausgleichen. Somit kann das Verbundsystem fest mit den beiden Glasplatten, welche die Frontseite 6 beziehungsweise Rückseite 1 des Moduls bilden, verbunden werden. Dies stellt sicher, dass keine Feuchtigkeit in das Modul eindringen kann. Das Licht 7 dringt somit durch das Frontglas 6 und die aktive Schicht 5 und wird daraufhin an der Metallfolie 3 (diffus) reflektiert und gelangt wieder in die aktive Schicht, um eine höhere Energieausbeute zu ermöglichen.

### Bezugszeichenliste:

- 1: Rückseitenträger
- 2: Trägerfolie
- 3: Metallfolie
- 4: Optische transparente Isolationsschicht
- 5: Aktive Schicht
- 6: Frontglas
- 7: Lichteinfall
- 8: Waferzelle
- 9: Frontkontakt
- 10: Elektrische Verbindung
- 11: Isolationsschicht
- 12: Leiterbahnen
- 13: Trägerfolie
- 14: Rückkontakt
- 15: Verstringung
- 16: Dünnschichtzelle mit interner Verstringung
- 17: Verbindung Busbar-Reflektor mit Zelle
- 18: Texturierter Reflektor

## Patentansprüche

1. Verbundsystem für Photovoltaik-Anwendung bestehend aus:
- einer Trägerfolie (2),
- einer Metallfolie (3), welche auf die Trägerfolie (2) aufgebracht ist, und
- einer Isolationsschicht (4), welche auf die Metallfolie (3) aufgebracht ist
**dadurch gekennzeichnet,**
- **dass** die Metallfolie (3) mit einer Oberflächentextur versehen ist,
- die Isolationsschicht (4) an Kontaktierungsstellen der Metallfolie (3) unterbrochen ist, und
- die Isolationsschicht (4) mit einem Verbindungsmittel versehen ist.

2. Verbundsystem nach Anspruch 1, **dadurch gekennzeichnet, dass** es sich bei dem Verbindungsmittel auf der Isolationsschicht (4)
- um einen Kleber handelt.

3. Verbundsystem nach Anspruch 1 oder 2, **dadurch gekennzeichnet, dass** die Isolationsschicht (4)
- aus einem transparenten und elektrisch isolierenden Material, vorzugsweise einem Kunststoff oder einem Kunstharz, besonders bevorzugt einem Epoxid-Harz besteht, oder aus einer Sol-Gel-Schicht oder einer dielektrischen Schicht besteht, und/oder im Wellenlängenbereich von 400 nm bis 1000 nm einen Brechungsindex von > 1,6 aufweist, oder
- wobei die Isolationsschicht (4) aus einem Kunststoff besteht, der haftende Eigenschaften aufweist, vorzugsweise aus Polyvinylbutyral (PVB).

4. Verbundsystem nach einem der Ansprüche 1 bis 3, **dadurch gekennzeichnet, dass** die Trägerfolie (2)
- aus Polyvinylbutyral, Polyvinylfluorid, Ethylenvinylacetat oder einem Kunststoff mit vergleichbaren thermischen und physikalischen Eigenschaften besteht, oder
- aus Polyethylenterephthalat in Form von biaxial orientiertem Polyester (boPET), und/oder
- auf der Rückseite beschichtet ist, vorzugsweise mit Aluminium.

5. Verbundsystem nach einem der Ansprüche 1 bis 5, **dadurch gekennzeichnet, dass** die Metallfolie (3)
- aus Kupfer, Aluminium oder Silber, oder vorzugsweise aus Zinn oder einer Zinnlegierung, oder einer plattierten Zinnfolie besteht; und/oder
- eine Dicke von mehr als 5 µm, vorzugsweise 10 µm bis 20 µm aufweist; und/oder
- mit einer Schicht versehen ist, die die Reflexion erhöht, wobei es sich vorzugsweise um Siliziumdioxid und/oder Titandioxid handelt wobei die Schicht auf der Metallfolie (3) vorzugsweise eine Reflexion von > 80% im Wellenlängenbereich von 300 nm bis 1000 nm aufweist; und/oder
- mit einer Oberflächentextur versehen ist, die vorzugsweise aus dreidimensionalen, regelmäßigen oder unregelmäßigen Strukturen, besonders bevorzugt aus Pyramiden oder Halbkugeln besteht, wobei die Textur vorzugsweise eine Höhe von 5 µm bis 10 µm, besonders bevorzugt eine zufällige Höhenverteilung von 5 µm bis 10 µm aufweist und/oder aus Pyramiden mit einem Scheitelwinkel von < 140° besteht; und/oder
- mit einer Oberflächentextur versehen ist, die vorzugsweise aus dreidimensionalen, regelmäßigen oder unregelmäßigen Strukturen, bevorzugt aus Pyramiden oder Halbkugeln besteht, wobei die Textur vorzugsweise eine Höhe von höchstens 1000 nm aufweist, wobei die Oberflächentextur und/oder die Pyramiden oder Halbkugeln besonders bevorzugt eine zufällige Höhenverteilung von 10-1000 nm, vorzugsweise 100-1000 nm aufweisen.

6. Verfahren zur Herstellung eines Verbundsystems nach einem der Ansprüche 1 bis 5 für PV-Module beinhaltend folgende Verfahrensschritte:
- Herstellen einer Metallfolie (3),
- Verbinden einer Metallfolie (3) mit einer Trägerfolie (2) durch eine haftende Verbindung,
- Verbinden der Metallfolie (3) und Trägerfolie (2) mit einer Isolationsschicht (4) durch eine haftende Verbindung, und
- Öffnen der Isolationsschicht (4) für Kontaktierung.

7. Verfahren zur Herstellung eines Verbundsystems nach einem der Ansprüche 1 bis 5 für PV-Module beinhaltend folgende Verfahrensschritte:
- Herstellen einer Metallfolie (3),
- Verbinden einer Metallfolie (3) mit einer Isolationsschicht (4) durch eine haftende Verbindung,
- Verbinden der Metallfolie (3) und Isolationsschicht (4) mit einer Trägerfolie (2) durch eine haftende Verbindung, und
- Öffnen der Isolationsschicht (4) für Kontaktierung.

8. Verfahren nach Anspruch 6 oder 7, **dadurch gekennzeichnet, dass**
- während oder nach dem Verbinden der Metallfolie (3) und der Trägerfolie (2) eine Leiterbahnstruktur (12), vorzugsweise mittels eines Laserverfahrens in die Metallfolie (3) geschnitten wird; und/oder
- vor oder nach dem Verbinden der Trägerfolie (2) mit der Metallfolie (3) eine Reflektortextur in die Metallfolie (3) geprägt wird; oder
- die Isolationsschicht (4) auf der der Metallfolie (3) zugewandten Seite eine Reflektortextur aufweist, die bei dem Verbinden auf die Metallfolie (3) übertragen wird; und/oder
- die Metallfolie (3) perforiert wird; und/oder
- die Metallfolie (3) in Transportrichtung während des Verbindens mit der Trägerfolie (2) beschnitten wird, vorzugsweise mittels eines Laserverfahrens; und/oder
- die Trägerfolie (2) aus Polyvinylbutyral besteht; und/oder
- als Isolationsschicht (4) ein Kunstharz, vorzugsweise ein Epoxid-Harz eingesetzt wird, welches mittels Temperatur und/oder UV-Strahlung ausgehärtet wird; oder
- die Isolationsschicht (4) aus einer dielektrische Schicht besteht, welche mittels eines PVD-Verfahrens aufgebracht wird; und/oder
- zur Herstellung einer elektrischen Verbindung (10) zwischen dem Verbundsystem und den PV-Zellen (5,8) ein thermisch aushärtender, elektrisch leitender Kleber auf den Kontaktierungsöffnungen verwendet wird, oder über einen Laserlötprozess erfolgt; und/oder
- das Verbundsystem mit den PV-Zellen (5,8) durch Lamination oder Verpressen verbunden wird, so dass eine Verschaltung der PV-Zellen (5,8) zum Modul entsteht.

9. Verfahren nach Anspruch 6 bis 8, **dadurch gekennzeichnet, dass** während des Laminationsvorganges in einem Verfahrensschritt zusätzlich
- elektrische Verbindungen (10) zwischen dem Verbundsystem und den PV-Zellen (5,8) hergestellt werden, vorzugsweise mittels Löten besonders bevorzugt unter Verwendung von tiefschmelzendem Lot;
- das Modul nach hinten verschlossen wird;
- ein Deckglas (6) aufgebracht wird und/oder
- die Einbettung der PV-Zellen (8) bewerkstelligt wird.

10. Verwendung eines Verbundsystems nach einem der Ansprüche 1 bis 5 zur Rückseitenkontaktierung von Waferzellen-Modulen, **dadurch gekennzeichnet, dass**
- eine Waferzelle (8), die beide Kontakte (9,14) auf der gleichen Seite hat mit diesen Kontakten auf die Leiterbahnstruktur (12) gesetzt und mit dieser verbunden wird; und/oder
- die Zelle während der Montage auf der Isolationsschicht haftet und so fixiert wird; und/oder
- die Trägerfolie (2) den rückseitigen Modulabschluss als Schutz vor Umwelteinflüssen bildet, oder
- die Trägerfolie (2) eine mechanische feste Verbindung mit einer rückseitigen Modulabdeckung eingeht.

11. Verwendung eines Verbundsystems nach einem der Ansprüche 1 bis 5 zur Erzeugung von Busbars in Dünnschichtzellenmodulen, **dadurch gekennzeichnet, dass**
- die Isolationsschicht (4) an den Längsseiten der Modulränder für die Kontaktierung (17) der Metallfolie (3,18) geöffnet ist, und
- die Metallfolie (3,18) längsseitig in zwei Teile geteilt ist, und somit eine Leiterbahnstruktur entsteht, die als Busbars dient,
- wobei die Metallfolie gleichzeitig als Reflektor dient.

12. Verwendung eines Verbundsystems nach Anspruch 11, **dadurch gekennzeichnet, dass**
- die Trägerfolie (2) die Dickendifferenz an den Modulrändern ausgleicht, die durch die fehlende Isolationsschicht an den Modulrändern des Dünnschichtzellenmoduls hervorgerufen wird; und/oder
- die Metallfolie (3) die aktive Schicht (5) in Segmenten oder über die gesamte Länge des Moduls an den Modulrändern kontaktiert (17); und/oder
- die Trägerfolie (2) den rückseitigen Modulabschluss als Schutz vor Umwelteinflüssen bildet, oder
- die Trägerfolie (2) eine mechanische feste Verbindung mit einer rückseitigen Modulabdeckung eingeht.

## Claims

1. A compound system for photovoltaic application, consisting of:
- a backing film (2),
- a metal film (3), which is applied onto the backing film (2), and
- an insulation layer (4), which is applied onto the metal film (3)
**characterised in that**,
- the metal film (3) is provided with a surface texture,
- the insulation layer (4) is interrupted at contact points of the metal film (3), and
- the insulation layer (4) is provided with a means of connection.

2. The compound system in accordance with Claim 1, **characterised in that**, the means of connection on the insulation layer (4)
- takes the form of an adhesive.

3. The compound system in accordance with Claim 1 or 2, **characterised in that**, the insulation layer (4)
- consists of a transparent and electrically insulating material, preferably a plastic or an artificial resin, particularly preferably an epoxy resin, or consists of a sol-gel layer or a dielectric layer, and/or has a refractive index of > 1.6 in the wavelength range from 400 nm to 1000 nm, or
- wherein the insulation layer (4) consists of a plastic that has adhesive properties, preferably of polyvinylbutyral (PVB).

4. The compound system in accordance with one of the Claims 1 to 3, **characterised in that**, the backing film (2)
- consists of polyvinylbutyral, polyvinyl fluoride, ethylene vinyl acetate or a plastic with comparable thermal and physical properties, or
- of polyethylene terephthalate in the form of a biaxially-oriented polyester (boPET), and/or
- is coated on the rear face, preferably with aluminium.

5. The compound system in accordance with one of the Claims 1 to 5, **characterised in that** the metal film (3)
- consists of copper, aluminium or silver, or preferably of tin or a tin alloy, or a bonded tin film, and/or
- has a thickness of more than 5 µm, preferably 10 µm to 20 µm, and/or
- is provided with a layer that increases the reflectivity, wherein this preferably takes the form of silicon dioxide and/or titanium dioxide, wherein the layer on the metal film (3) preferably has a reflectivity of > 80% in the wavelength range from 300 nm to 1000 nm, and/or
- is provided with a surface texture, which preferably consists of three-dimensional, regular or irregular structures, particularly preferably of pyramids or hemispheres, wherein the texture preferably has a height of 5 µm to 10 µm, particularly preferably has a random distribution from 5 µm to 10 µm, and/or consists of pyramids with an apex angle of < 140°; and/or
- is provided with a surface texture, which preferably consists of three-dimensional, regular or irregular structures, particularly preferably of pyramids or hemispheres, wherein the texture preferably has a height of a maximum of 1000 nm, wherein the surface texture and/or the pyramids or hemispheres particularly preferably have a random height distribution of 10-1000 nm, preferably of 100-1000 nm.

6. A method for the manufacture of a compound system in accordance with one of the Claims 1 to 5 for PV modules comprising the following steps:
- manufacture of a metal film (3),
- connection of a metal film (3) with a backing film (2) by means of an adhesive joint,
- connection of the metal film (3) and backing film (2) with an insulation layer (4) by means of an adhesive joint, and
- opening up of the insulation layer (4) for the purpose of making contacts.

7. A method for the manufacture of a compound system in accordance with one of the Claims 1 to 5 for PV modules comprising the following steps:
- manufacture of a metal film (3),
- connection of a metal film (3) with an insulation layer (4) by means of an adhesive joint,
- connection of the metal film (3) and insulation layer (4) with a backing film (2) by means of an adhesive joint, and
- opening up of the insulation layer (4) for the purpose of making contacts.

8. The method in accordance with Claim 6 or 7, **characterised in that**
- during or after the connection of the metal film (3) and the backing film (2) a conducting track structure is cut into the metal film (3), preferably by means of a laser process; and/or
- before or after the connection of the backing film (2) with the metal film (3) a reflector texture is embossed into the metal film (3), or
- the insulation layer (4) has a reflector structure on the face facing towards the metal film (3), which structure is transferred onto the metal film (3) in the course of the connection process, and/or
- the metal film (3) is perforated; and/or
- during the connection process the metal film (3) is cut in the direction of transport, preferably by means of a laser process; and/or
- the backing film (2) consists of polyvinylbutyral; and/or
- an artificial resin, preferably an epoxy resin, is deployed as the insulation layer (4), which resin is cured by means of temperature and/or UV-radiation; or
- the insulation layer (4) consists of a dielectric layer, which is applied by means of a PVD process; and/or
- for purposes of manufacturing an electrical connection (10) between the compound system and the PV cells (5, 8) a thermally cured electrically conducting adhesive is used on the contact openings, or takes place via a laser soldering process; and/or
- the compound system is connected with the PV cells (5, 8) by means of lamination, or the application of pressure, so that an electrical connection is made between the PV cells (5, 8) and the module.

9. The method in accordance with Claims 6 to 8, **characterised in that**, during the lamination process in an additional step of the method
- electrical connections (10) are made between the compound system and the PV cells (5, 8), preferably by means of soldering, particularly preferably using a low melting point solder;
- the module is closed off at the rear;
- a cover glass (6) is applied, and/or
- the embedding of the PV cells (8) is achieved.

10. The use of a compound system in accordance with one of the Claims 1 to 5, for purposes of making contact with the rear face of wafer cell modules, **characterised in that**
- a wafer cell (8), which has both contacts (9, 14) on the same side, with these contacts is affixed on the conducting track structure (12) and is connected with the latter; and/or
- during installation the cell adheres to the insulation layer and is thus fixed; and/or
- the backing film (2) provides closure for the module on its rear face as protection from environmental influences, or
- the backing film (2) enters into a mechanically robust connection with a covering on the rear face of the module.

11. The use of a compound system in accordance with one of the Claims 1 to 5, for purposes of creating bus bars in thin-layer cell modules, **characterised in that**
- the insulation layer (4) is opened up on the longitudinal faces of the module edges for purposes of making contact (17) with the metal film (3, 18), and
- the metal film (3, 18) is divided into two parts on its longitudinal face, and a conducting track structure is thus formed, which serves as bus bars,
- wherein the metal film at the same time serves as a reflector.

12. The use of a compound system in accordance with Claim 11, **characterised in that**
- the backing film (2) compensates for the thickness difference on the module edges that is brought about as a result of the lack of an insulation layer on the module edges of the thin-layer cell module; and/or
- the metal film (3) makes contact with the active layer (5) in segments, or over the whole length of the module on the module edges (17); and/or
- the backing film (2) provides closure for the module on its rear face as protection from environmental influences, or
- the backing film (2) enters into a mechanically robust connection with a covering on the rear face of the module.

## Revendications

1. Système de connexion pour une application photovoltaïque, se composant :
- d'une feuille de support (2),
- d'une feuille métallique (3), laquelle est appliquée sur la feuille de support (2), et
- d'une couche d'isolation (4), laquelle est appliquée sur la feuille métallique (3),
**caractérisé en ce que**,
- la feuille métallique (3) est munie d'une texture de surface,
- la couche d'isolation (4) étant interrompue au niveau d'emplacements d'établissement de contact de la feuille métallique (3), et
- la couche d'isolation (4) étant munie d'un agent de liaison.

2. Système de connexion selon la revendication 1, **caractérisé en ce que**, en ce qui concerne l'agent de liaison sur la couche d'isolation (4),
- il s'agit d'un adhésif.

3. Système de connexion selon les revendications 1 ou 2, **caractérisé en ce que** la couche d'isolation (4)
- se compose d'un matériau transparent et isolant électriquement, de préférence d'une matière synthétique ou d'une résine synthétique, de manière particulièrement préférée d'une résine époxy, ou bien d'une couche sol-gel ou d'une couche diélectrique, et/ou présente un indice de réfraction > 1,6 dans la plage des longueurs d'onde de 400 nm à 1000 nm, ou bien
- la couche d'isolation (4) se composant d'une matière synthétique, laquelle présente des propriétés d'adhérence, de préférence en polyvinylbutyral (PVB).

4. Système de connexion selon les revendications 1 à 3, **caractérisé en ce que** la feuille de support (2)
- se compose de polyvinylbutyral, de polyfluorure de vinyle, d'éthylène-acétate de vinyle ou d'une matière synthétique avec des propriétés thermiques et physiques comparables, ou
- de polyéthylène téréphtalate sous la forme de polyester orienté biaxialement (boPET), et/ou
- est revêtue sur la face arrière, de préférence avec de l'aluminium.

5. Système de connexion selon l'une des revendications 1 à 5, **caractérisé en ce que** la feuille métallique (3)
- se compose de cuivre, d'aluminium ou d'argent, ou de préférence d'étain ou d'un alliage à base d'étain, ou d'un film d'étain plaqué ; et/ou
- présente une épaisseur de plus de 5 µm, de préférence de 10 µm à 20 µm ; et/ou
- est munie d'une couche, laquelle augmente la réflexion, moyennant quoi il s'agit de préférence de dioxyde de silicium et/ou de dioxyde de titane, moyennant quoi la couche sur la feuille métallique (3) présente de préférence une réflexion > 80% dans la plage des longueurs d'onde de 300 nm à 1000 nm ; et/ou
- est munie d'une texture de surface, laquelle se compose de préférence de structures tridimensionnelles régulières ou irrégulières, de manière particulièrement préférée de pyramides ou demi-sphères, moyennant quoi la texture présente de préférence une hauteur de 5µm à 10 µm, de manière particulièrement préférée une répartition en hauteur aléatoire de 5 µm à 10 µm et/ou se compose de pyramides avec un angle au sommet < 140° ; et/ou
- est munie d'une texture de surface, laquelle se compose de préférence de structures tridimensionnelles régulières ou irrégulières, de manière particulièrement préférée de pyramides ou demi-sphères, moyennant quoi la texture présente de préférence une hauteur d'un maximum de 1000 nm, moyennant quoi la texture de surface et/ou les pyramides ou demi-sphères présentent de manière particulièrement préférée une répartition en hauteur aléatoire de 10-1000 nm, de préférence de 100-1000 nm.

6. Procédé pour la fabrication d'un système de connexion selon l'une des revendications 1 à 5 pour modules PV comprenant les étapes suivantes du procédé:
- fabrication d'une feuille métallique (3),
- lier une feuille métallique (3) avec une feuille de support (2) grâce à une liaison adhésive,
- lier la feuille métallique (3) et la feuille de support (2) avec une couche d'isolation (4) grâce à une liaison adhésive, et
- ouvrir la couche d'isolation (4) pour l'établissement de contact.

7. Procédé pour la fabrication d'un système de connexion selon l'une des revendications 1 à 5 pour modules PV comprenant les étapes suivantes du procédé:
- fabrication d'une feuille métallique (3),
- lier une feuille métallique (3) avec une couche d'isolation (4) grâce à une liaison adhésive,
- lier la feuille métallique (3) et la couche d'isolation (4) avec une feuille de support (2) grâce à une liaison adhésive, et
- ouvrir la couche d'isolation (4) pour l'établissement de contact.

8. Procédé selon les revendications 6 ou 7, **caractérisé en ce que**,
- pendant ou après la liaison de la feuille métallique (3) et de la feuille de support (2), on découpe une structure de piste conductrice (12) dans la feuille métallique (3), de préférence à l'aide d'un procédé laser ; et/ou
- **en ce qu'**avant ou après la liaison de la feuille de support (2) avec la feuille métallique (3), on estampe une texture de réflecteur dans la feuille métallique (3) ; ou bien
- **en ce que** la couche d'isolation (4) présente une texture de réflecteur sur la face tournée vers la feuille métallique (3), laquelle est transmise sur la feuille métallique (3) lors de la liaison ; et/ou
- **en ce que** la feuille métallique (3) est perforée ; et/ou
- **en ce que** la feuille métallique (3) est rognée en direction de transport pendant la liaison avec le feuille de support (2), de préférence à l'aide d'un procédé laser ; et/ou
- **en ce que** la feuille de support (2) se compose de polyvinylbutyral ; et/ou
- **en ce qu'**une résine synthétique, de préférence une résine époxy, est utilisée en tant que couche d'isolation (4), laquelle est durcie à l'aide de température et/ou d'un rayonnement UV ; et/ou
- **en ce que** la couche d'isolation (4) se compose d'une couche diélectrique, laquelle est appliquée à l'aide d'un procédé PVD ; et/ou
- **en ce que**, pour la fabrication d'une liaison électrique (10) entre le système de connexion et les cellules PV (5, 8), on fait appel à un adhésif électro-conducteur à durcissement thermique sur les ouvertures d'établissement de contact, ou bien à un processus de brasage par laser ; et/ou
- **en ce que** le système de connexion est relié aux cellules PV (5, 8) par laminage ou pressage, de sorte à obtenir une connexion des cellules PV (5, 8) au module.

9. Procédé selon les revendications 6 à 8, **caractérisé en ce que**, pendant le processus de laminage lors d'une étape du procédé, on effectue additionnellement
- l'établissement de liaisons électriques (10) entre le système de connexion et les cellules PV (5, 8), de préférence à l'aide d'un brasage, de manière particulièrement préférée en utilisant un alliage d'apport à fusion basse ;
- la fermeture du module vers l'arrière;
- l'application d'un verre de recouvrement (6) et/ou
- la réalisation de l'intégration des cellules PV (8).

10. Utilisation d'un système de connexion selon l'une des revendications 1 à 5 pour l'établissement de contact de face arrière de modules à cellules de tranches de silicium, **caractérisée en ce que**,
- une cellule de tranche de silicium (8), laquelle a les deux contacts (9, 14) sur la même face, est posée avec ces contacts sur la structure de piste conductrice (12) en étant reliée à celle-ci ; et/ou
- **en ce que** la cellule adhère à la couche d'isolation pendant le montage en étant fixée de la sorte ; et/ou
- **en ce que** la feuille de support (2) forme la fermeture de module arrière en guise de protection contre les influences environnementales, ou
- **en ce que** la feuille de support (2) établit une liaison mécanique solide avec un recouvrement de module arrière.

11. Utilisation d'un système de connexion selon l'une des revendications 1 à 5 pour la génération de busbars dans des modules à cellules à couche mince, **caractérisée en ce que**
- la couche d'isolation (4) est ouverte sur les côtés longitudinaux des bords du module pour l'établissement de contact (17) de la feuille métallique (3, 18), et
- **en ce que** la feuille métallique (3, 18) est divisée en deux parties du côté longitudinal, et une structure de piste conductrice étant ainsi formée, laquelle sert de busbars,
- moyennant quoi la feuille métallique sert simultanément de réflecteur.

12. Utilisation d'un système de connexion selon la revendication 11, **caractérisée en ce que**
- la feuille de support (2) compense la différence d'épaisseur sur les bords du module, laquelle est provoquée par l'absence de la couche d'isolation sur les bords de module du module à cellules à couche mince ; et/ou
- **en ce que** la feuille métallique (3) établit le contact (17) avec la couche active (5) par segments ou bien sur toute la longueur du module au niveau des bords du module ; et/ou
- **en ce que** la feuille de support (2) forme la fermeture de module arrière en guise de protection contre les influences environnementales, ou bien
- **en ce que** la feuille de support (2) établit une liaison mécanique solide avec un recouvrement de module arrière.
